# EUROPEAN PATENT APPLICATION

(11) **EP 4 604 394 A1**
(43) Date of publication of application: **20.08.2025**
(21) Application number: 24157384.9
(22) Date of filing: 13.02.2024
(51) Int. Cl.: H03K 17/0412, H02M 1/088, H02M 3/158, H03K 17/16, H03K 17/687

(54) **A SWITCHING STAGE OF A SWITCHED MODE POWER SUPPLY, SMPS, AS WELL AS AN SMPS AND CORRESPONDING METHOD**

(71) Applicant: Nexperia B.V., 6534 AB Nijmegen (NL)
(72) Inventor: Qu, Yong, Manchester (GB); Lange, Doug, Manchester (GB); Sherman, Daniel, Manchester (GB); Radici, Christian, Manchester (GB)
(74) Representative: Pjanovic, Ilija

(57) **Abstract**

A switching stage of a Switched Mode Power Supply, SMPS, said switching stage comprising a switching element comprising a GaN transistor connected in series with a Metal-Oxide-Semiconductor, MOS, Field Effect Transistor, FET, thereby defining a mid-node in between said GaN transistor and said MOSFET, a controller arranged for driving a gate terminal of said MOSFET based on an Pulse Width Modulation, PWM, input signal, wherein said controller comprises first switch circuitry arranged for providing a low ohmic path between said mid-node and said gate terminal of said MOSFET and control circuitry arranged for controlling said switch circuitry based on said PWM input signal.

## Description

### Technical field

The present disclosure generally relates to the field of Switched Mode Power Supplies, SMPS, and, more specifically, to an improved method for driving the gate terminal of the switching element.

### Background

A conventional Boost Power Factor Correction, PFC, converter is a component in power electronics, designed to improve the power factor and efficiency of power supplies. Power Factor Correction may be of importance in electricity consumption, especially in applications with non-linear loads, to minimize reactive power and enhance overall power utilization.

In a typical boost PFC converter, the circuit consists of certain elements such as a boost topology, a transformer (/inductor), and a controller IC. The primary goal is to shape the input current waveform to be in-phase with the input voltage, thereby improving the power factor. This is achieved through the manipulation of the boost converter, which increases the input voltage to a desired level and shapes the current waveform.

The transformer T1 in the conventional setup plays a particular role. It not only provides isolation between the input and output but also serves as a means to supply power to the controller IC. The secondary winding of the transformer offers a power rail for the controller IC, ensuring its proper functioning.

Current-sensing in the traditional design is accomplished using a resistor dedicated to measuring the current in the circuit. The measured current is typically the current that flows through the switching element of the converter, i.e. the Metal Oxide Semiconductor, MOS, Field Effect Transistor, FET.

This information may be of importance for the feedback loop in the controller IC to adjust the duty cycle of the switching element, thereby improving the power delivered to the load.

The gate-driving strength of the switching element is controlled by a gate resistor. Proper adjustment of this resistor ensures efficient switching and minimizes losses in the power stage. It also affects the overall performance and reliability of the PFC circuit.

To address the growing demand for power density, the industry trend is shifting towards innovative solutions. One notable change involves replacing the bulky transformer with a low-profile inductor. This reduces the overall size and weight of the PFC converter, catering to applications where space is a premium.

Furthermore, advancements in sensing technology introduce a lossless sense-FET, eliminating the need for the current-sensing resistor. This enhances efficiency and reduces losses in the PFC circuit, contributing to improved overall performance.

One of the disadvantages of the above mentioned controller IC's is that they may induce all kinds of ElectroMagnetic Interference, EMI. Another disadvantage relates to efficiency of the corresponding SMPS.

### Summary

It would be advantageous to achieve a switching stage of a Switched Mode Power Supply, SMPS, that overcomes at least some of the above stated disadvantages. It would further be advantageous to achieve a corresponding SMPS and methods for operating such a switching stage.

In a first aspect of the present disclosure, there is provided a switching stage of a Switched Mode Power Supply, SMPS, said switching stage comprising:
- a switching element comprising a GaN transistor connected in series with a Metal-Oxide-Semiconductor, MOS, Field Effect Transistor, FET, thereby defining a mid-node (Vm) in between said GaN transistor and said MOSFET;
- a controller arranged for driving a gate terminal of said MOSFET based on an Pulse Width Modulation, PWM, input signal;
wherein said controller comprises:
- first switch circuitry ("M2") arranged for providing a low ohmic path between said mid-node and said gate terminal of said MOSFET;
- control circuitry ("State machine") arranged for controlling said switch circuitry based on said PWM input signal.

To better understand the concepts presented in this disclosure, first a traditional controller used for driving the gate terminal of a switching element in a switched mode power supply is examined in more detail. The controller is powered by a supply voltage and governs the MOSFET's gate terminal based on a Pulse Width Modulation, PWM, input signal. When the PWM signal is high, the corresponding gate terminal receives a high signal, initiating conduction in the switching element. Conversely, a low PWM signal results in a low signal at the gate terminal, causing the switching element to cease conduction.

The switching element, often a MOSFET, may have a gate-source capacitance. During a high PWM signal, this capacitance is charged. Once the voltage over the gate-source capacitance surpasses a threshold voltage, the MOSFET enters the "on" or conducting state. The threshold voltage is the minimum required to establish a conducting channel between the MOSFET's source and drain terminals.

The inventors have found that the conventional controller may generate Electromagnetic Interference, EMI, during the gate-source capacitance charging. EMI issues are linked to the charging profile, specifically the rate of change of voltage (dv/dt) and/or current (di/dt) provided to the gate-source capacitance.

Furthermore, the inventors noted that parasitic capacitance at the switching node of the Switch-Mode Power Supply, SMPS, is dissipated undesirably in the channels of the switching element during MOSFET turn-on. In this context, the switching node is typically linked to the switching element's drain.

The disclosure proposes a solution to utilize the energy stored in the parasitic capacitance at the switching node more effectively. Traditionally, the current through the GaN transistor would only start (the stored energy would discharge) once the MOSFET's gate terminal reached the threshold voltage, indicating the MOSFET's transition to the conducting state.

The disclosure suggests introducing a low-ohmic path, facilitated by the first switch circuitry, between the mid-node and the gate terminal of the MOSFET. This arrangement enables the stored energy in the parasitic capacitance to efficiently charge the gate-source capacitance of the MOSFET, improving the use of the stored energy and mitigating EMI concerns during the charging process.

In an example, the switching stage further comprises:
- a buffer capacitor (Cx);
- a rectifying device (Dx) connected in between said mid-node and said buffer capacitor, such that said buffer capacitor is charged from said mid-node;
- a voltage regulator (LDO), connected to said buffer capacitor, and arranged for providing a supply voltage;

wherein said controller further comprises:
   - second switch circuitry ("M1") arranged for providing a low ohmic path between said supply voltage and said gate terminal of said MOSFET of said switching element;
wherein said control circuitry is further arranged for controlling said second switch circuitry ("M1") based on a voltage level of said mid-node and based on said PWM input signal.

The above mentioned voltage regulator may be used within the controller for empowering all kinds of functions within the controller.

Controllers in SMPS's, which play a role in regulating the energy flow in power supply systems, can be implemented using various electronic components. Microcontrollers, MCUs, are commonly used, offering programmability and flexibility through integrated CPUs and memory. Digital Signal Processors, DSPs, may be preferred for applications requiring high-speed signal processing and complex control algorithms. Field-Programmable Gate Arrays, FPGAs, may provide flexibility for customized digital circuit implementation, making them suitable for, for example, boost converters with specific control requirements.

The example as disclosed above may be beneficial as the power required for the converter to operate is drawn from the mid-node. There is no additional, separate, power branch to power the controller.

The energy may be harvested from the mid-node, and may be stored in a buffer capacitor. The energy may be harvested whenever the voltage at the mid-node is above a particular threshold. A rectifying device, like a diode, will ensure that the flow of power is in one direction, i.e. from the mid-node to the buffer capacitor.

One of the advantages of the above, is that the SMPS no longer needs a transformer. In prior art situations, typically a transformer was used, wherein the secondary side of the transformer was utilized for powering the controller. The primary side of the transformer acted as an inductor for, for example, the boost converter.

Following the above, by extracting power from the mid-node, the implementation of a transformer is mitigated.

The second switch circuitry is arranged for providing a low ohmic path between the supply voltage and the gate terminal of the MOSFET of the switching element. This will allow the gate-source capacitance of the MOSFET of the switching element to charge up. In this case, the charging is obtained from the supply voltage that is provided by the voltage regulator.

As such, the second switch circuitry is arranged to utilize the supply voltage obtained from the voltage regulator to charge the gate-source capacitance of the MOSFET of the switching element and the first switch circuitry is arranged to utilize the voltage at the mid-node, i.e. the charge present in the parasitic capacitance of the switching node of the SMPS, to charge the gate-source capacitance of the MOSFET of the switching element.

The control circuitry may be arranged for controlling the second switch circuitry based on a voltage level of the mid-node and based on the PWM input signal.

For example, the controller may comprise a first comparator ("comp1") arranged for comparing said voltage at said mid-node with a predefined first reference voltage, wherein said control circuitry is arranged for controlling said second switch circuitry ("M1") based on said comparison.

The comparator will thus determine whether the voltage at the mid-node will drop below a predefined first reference value. If that's the case, then the controller may activate, or enable, the second switch circuitry.

In a specific example, the first switch circuitry comprises:
- a first control MOSFET ("M2"), wherein a drain terminal of said first control MOSFET is connected to said mid-node, and wherein a source terminal of said first control MOSFET is connected to said gate terminal of said MOSFET of said switching element.

It is noted that the body terminal of the first control MOSFET may be connected to ground.

In a further example, the second switch circuitry comprises:
- a second control MOSFET ("M1"), wherein a source terminal of said second control MOSFET is connected to said supply voltage, and wherein a drain terminal of said second control MOSFET is connected to said gate terminal of said MOSFET of said switching element.

In yet another example, the control circuitry ("State machine") is further arranged for controlling said first switch circuitry based on said PWM input signal and based on a voltage level at said gate terminal of said MOSFET of said switching element.

In a further example, the control circuitry further comprises:
- a second comparator ("Comp2") arranged for comparing said voltage level at said gate terminal of said MOSFET of said switching element with a predefined second reference voltage, wherein said control circuitry is arranged for controlling said first switch circuitry based on said PWM input signal and based on said comparison.

In a second aspect of the present disclosure, there is provided a Switched Mode Power Supply, SMPS, comprising a switching stage in accordance with any of the previous examples.

It is noted that the advantages as explained with respect to the first aspect of the present disclosure, being the switching stage of a Switched Mode Power Supply, are also applicable to the second aspect of the present disclosure, being the Switched Mode Power Supply.

A SMPS, or Switch-Mode Power Supply, may encompass different types of power converters, each designed for specific applications. Among them are a flyback Converter which utilizes a transformer to store and transfer energy during the switching cycle. A boost converter steps up the input voltage to produce a higher output voltage. A buck converter steps down the input voltage to generate a lower output voltage, commonly used for voltage regulation. A forward Converter operates with continuous energy transfer during both on and off cycles using a transformer. A resonant converter uses resonant components for soft switching, reducing losses and enhancing efficiency.

In a third aspect of the present disclosure, there is provided a method of operating a switching stage in accordance with any of the previous examples, wherein said method comprises the steps of:
- controlling, by said control circuity, said switch circuitry based on said PWM input signal.

In an example, the step of controlling comprises:
- enabling, by said control circuitry, said switch circuitry such that said switch circuitry provides said low ohmic path between said mid-node and said gate terminal of said MOSFET upon a transition in said PWM input signal.

In a further example, the method further comprises the step of:
- controlling, by said control circuity, said second switch circuitry based on said voltage of said mid-node and based on said PWM input signal.

In yet another example, the controller further comprises a first comparator ("comp1"), wherein said method further comprises the step of:
- comparing, by said first comparator ("comp1") said voltage at said mid-node with a predefined first reference voltage,

And wherein said step of controlling comprises:
- controlling, by said control circuitry, said second switch circuitry ("M1") based on said comparison.

In a fourth aspect of the present disclosure, there is provided a computer program product comprising a computer readable medium having instructions stored thereon which, when executed by a controller of a Switched Mode Power Supply, SMPS, cause said SMPS to implement a method in accordance with any of the examples as provided above.

In the appended figures, similar components and/or features may have the same reference label. Further, various components of the same type may be distinguished by following the reference label by a dash and a second label that distinguishes among the similar components. If only the first reference label is used in the specification, the description is applicable to any one of the similar components having the same first reference label irrespective of the second reference label.

The above and other aspects of the disclosure will be apparent from and elucidated with reference to the examples described hereinafter.

### Brief description of the figures

Fig. 1 shows an example state-of-the-art cascode GaN device
Fig. 2 shows a block diagram of a Switched Mode Power Supply, SMPS, having a switching stage in accordance with the present disclosure;
Fig. 3 shows a further block diagram of a Switched Mode Power Supply, SMPS, having a switching stage in accordance with the present disclosure;
Fig. 4 shows yet another block diagram of a SMPS, having a switching stage in accordance with the present disclosure;
Fig. 5. Shows a timing diagram corresponding to the concept shown in figure 3.

### Detailed description

It is noted that in the description of the figures, same reference numerals refer to the same of similar components performing a same of essentially similar function.

A more detailed description is made with reference to particular examples, some of which are illustrated in the appended drawings, such that the features of the present disclosure may be understood in more detail. It is noted that the drawings only illustrate typical examples and are therefore not to be considered to limit the scope of the subject matter of the claims. The drawings are incorporated for facilitating an understanding of the disclosure and are thus not necessarily drawn to scale. Advantages of the subject matter as claimed will become apparent to those skilled in the art upon reading the description in conjunction with the accompanying drawings.

The ensuing description above provides preferred exemplary embodiment(s) only, and is not intended to limit the scope, applicability, or configuration of the disclosure. Rather, the ensuing description of the preferred exemplary embodiment(s) will provide those skilled in the art with an enabling description for implementing a preferred exemplary embodiment of the disclosure, it being understood that various changes may be made in the function and arrangement of elements, including combinations of features from different embodiments, without departing from the scope of the disclosure.

Unless the context clearly requires otherwise, throughout the description and the claims, the words "comprise," "comprising," and the like are to be construed in an inclusive sense, as opposed to an exclusive or exhaustive sense; that is to say, in the sense of "including, but not limited to." As used herein, the terms "connected," "coupled," or any variant thereof means any connection or coupling, either direct or indirect, between two or more elements; the coupling or connection between the elements can be physical, logical, electromagnetic, or a combination thereof. Additionally, the words "herein," "above," "below," and words of similar import, when used in this application, refer to this application as a whole and not to any particular portions of this application. Where the context permits, words in the Detailed Description using the singular or plural number may also include the plural or singular number respectively. The word "or" in reference to a list of two or more items, covers all the following interpretations of the word: any of the items in the list, all of the items in the list, and any combination of the items in the list.

These and other changes can be made to the technology considering the following detailed description. While the description describes certain examples of the technology, and describes the best mode contemplated, no matter how detailed the description appears, the technology can be practiced in many ways. Details of the system may vary considerably in its specific implementation, while still being encompassed by the technology disclosed herein. As noted above, particular terminology used when describing certain features or aspects of the technology should not be taken to imply that the terminology is being redefined herein to be restricted to any specific characteristics, features, or aspects of the technology with which that terminology is associated. In general, the terms used in the following claims should not be construed to limit the technology to the specific examples disclosed in the specification, unless the Detailed Description section explicitly defines such terms. Accordingly, the actual scope of the technology encompasses not only the disclosed examples, but also all equivalent ways of practicing or implementing the technology under the claims.

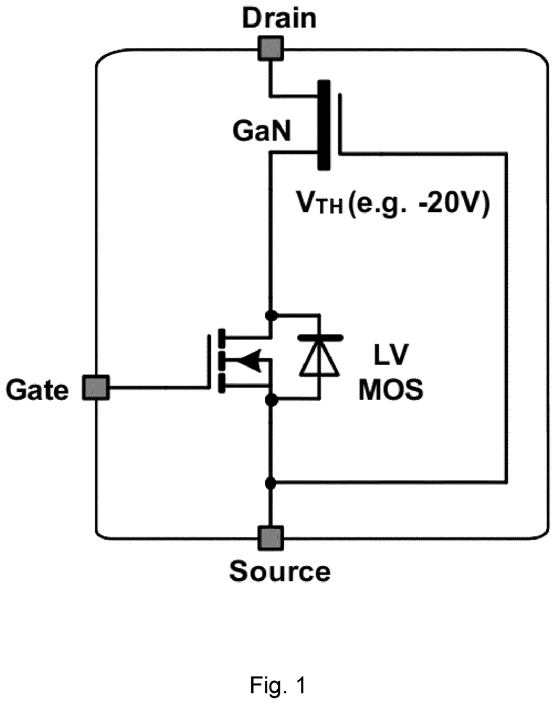

Figure 1 shows an example state-of-the-art cascode GaN device. Figure 1 shows a depletion-mode Gallium Nitride (d-GaN) HEMT which is chip-to-chip connected with a silicon MOSFET located over the GaN HEMT. As the gate and source of the GaN device are individually connected with the source and drain of the MOSFET in a cascode configuration, the GaN device can be indirectly turned off by turning off the MOSFET device.

In the device shown, when the GaN device is indirectly turned off by turning off the MOSFET device, then a middle point voltage Vmid-node reaches the absolute value of the GaN threshold voltage VTH (e.g., -20V) because Vmid-node = - VGS (of the GaN device).

Due to the package parasitic impedance and the capacitance mismatch between the Cascode GaN and MOSFET devices, Vmid-node often suffers from overshoots which may introduce reliability degradation of the GaN gate. To reduce the reliability degradation, a large capacitor, CX, is often integrated into the MOSFET die to mitigate the middle point voltage overshoot during the turn-off period but also reduce the risk of unwanted cascode turn-on events due to oscillations across the cascode voltage.

However, the energy stored in the capacitor CX gets directly dissipated on the MOSFET channel during the turn-on moment and the benefits arising from the GaN device are diminished if all these provisions need to be added.

Consequently, there is a trade-off between reducing overshoot and reducing power losses. A larger capacitor CX leads to a reduced VM overshoot, however increases the size of chip required and increases power loss.

Moreover, as the leakage current of the GaN device in the off state is typically higher than the MOSFET, a bleeder resistor RX is integrated into the MOSFET die to sink the GaN leakage current, which undesirably compromises efficiency.

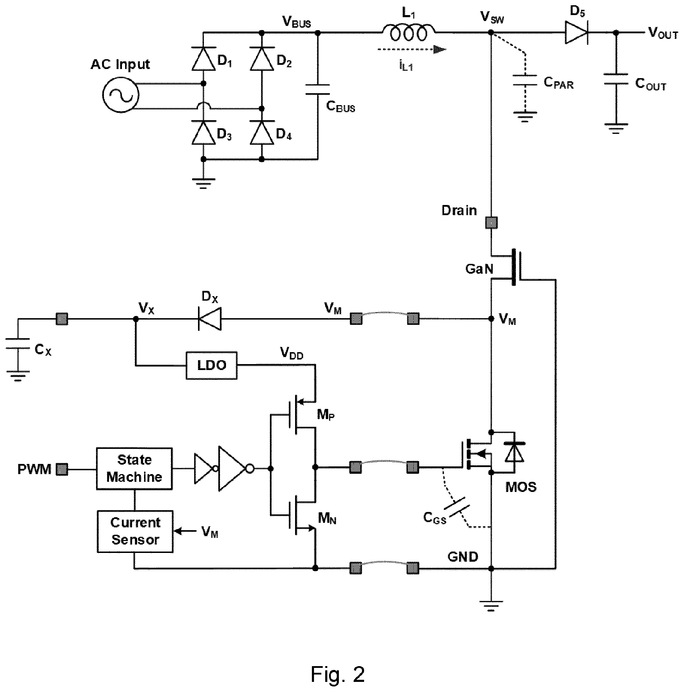

Figure 2 discloses a modified design for the gate driver circuit in a switched-mode power supply, SMPS, with the goal of enhancing efficiency and performance. In this design, energy dissipation during MOSFET turn-on is remedied by an energy harvesting mechanism from the mid-node VM, which represents the voltage at a specific point in the circuit.

This energy harvesting is facilitated through the use of a diode, DX, and a capacitor, CX. The diode ensures that energy flows in one direction, and the capacitor accumulates and stores this energy on a cycle-by-cycle basis. Additionally, the design incorporates a current-sensing function by measuring the MOSFET drain-to-source voltage, VDS, during the channel's on state, expressed as VDS = RDSON * IDS.

This measurement provides information about the current flowing through the MOSFET.

This design offers several advantages over a conventional SMPS design, including higher power density, increased power efficiency, and lower hardware costs. Specifically, the removal of certain components, such as the current-sensing resistor and transformer, compensates for the extra cost associated with adding an additional Gallium Nitride, GaN, device to the design.

Overall, this modified design represents an improved approach to SMPS gate driver circuits, aiming to optimize energy usage, introduce a current-sensing function, and achieve higher power density with reduced hardware costs compared to the traditional design.

The cascode GaN module depicted in Fig. 2, despite its advancements, may still present three areas for potential improvement. Firstly, there is a susceptibility to Electromagnetic Interference, EMI, issues, attributed to uncontrolled factors such as di/dt and dv/dt during the switching process. These uncontrolled variables could lead to unwanted EMI problems, suggesting a need for mitigation strategies in the design.

Secondly, there is a concern related to the dissipation of energy in Cpar when the inductor current, iL1, is positive and the input Pulse Width Modulation , PWM, signal goes high. In this scenario, the energy stored in Cpar is undesirably dissipated on the channels of the GaN and MOSFET during the turn-on phase of the cascode GaN.

Cpar, in this context, encompasses the cumulative parasitic capacitance at the switching node Vsw. Addressing this issue may be of importance to improve the energy usage and minimizing losses during the switching transitions.

Thirdly, the negative inductor current, iL, coupled with a high PWM signal necessitates the rapid turn-on of the MOSFET to mitigate losses associated with MOSFET body diode rectification. The efficiency of the cascode GaN module is thus contingent on the swift response of the MOSFET under these specific conditions. Enhancements in the control and management of these aspects could contribute to an overall improvement in the performance and reliability of the cascode GaN module.

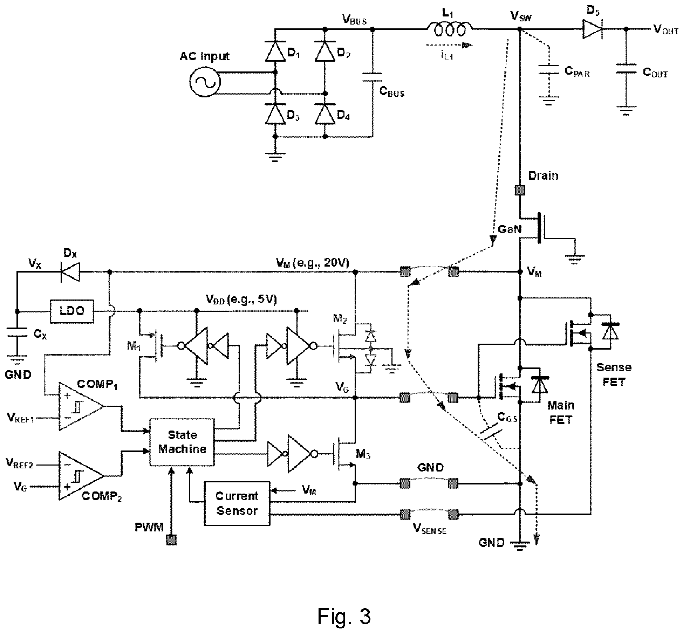

Reference is now made to figure 3.

The presented disclosure is designed to cater to both logic level, LL, and standard level, SL, gate Metal-Oxide-Semiconductor Field-Effect Transistors, MOSFETs, with a specific focus on minimizing gate driving losses, particularly in the case of LL gate MOSFETs. The MOSFET and Gallium Nitride, GaN. in the system have voltage ratings of 30V and 650V, respectively.

In Figure 3, the block diagram outlines the proposed low-Electromagnetic Interference, EMI, self-drive GaN concept in a boost Power Factor Correction, PFC, configuration. Here, the body of transistor M2 is connected to the ground, a strategy employed to disable its body diode reverse conduction. This connection serves to increase the threshold voltage when the MOSFET gate voltage VG becomes high. Notably, this configuration leverages generic Complementary Metal-Oxide-Semiconductor, CMOS, technology features.

In accordance with the present disclosure, first switch circuitry is arranged for providing a low ohmic path between said mid-node and said gate terminal of said MOSFET. In this case, the first switch circuitry is implemented as the MOSFET M2.

In accordance with the present disclosure, the second switch circuitry arranged for providing a low ohmic path between said supply voltage and said gate terminal of said MOSFET of said switching element. In this case, the second switch circuitry is implemented as the MOSFET M1.

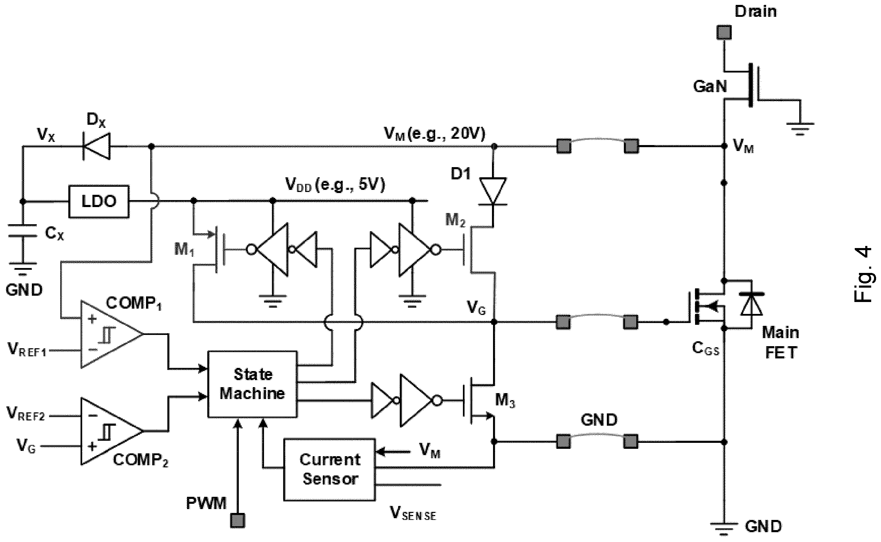

Reference is made to figure 4. In addition to the embodiment shown in figure 3, an additional diode D1 is placed in series with the MOSFET M2 to ensure that there is no conductive path from node Vg to the node Vm.

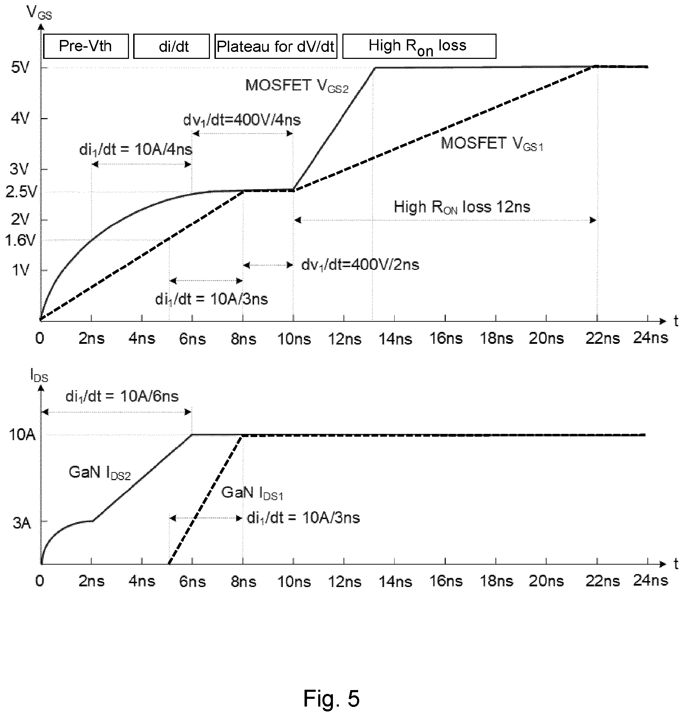

Figure 5 delves into the principle of the proposed low-EMI gate driving. The conventional and proposed gate driving profiles are represented by MOSFET VGS1 and VGS2, respectively.

The corresponding GaN drain-to-source currents are denoted as IDS1 and IDS2. When the inductor current iL1 is positive and the input Pulse Width Modulation, PWM, signal goes high, i.e.at the transition point, the energy in Cpar is efficiently recycled to charge the MOSFET gate CGS.

This approach prevents energy dissipation on the MOSFET channel, and instead redirects it through a specific current path involving CPAR, GaN, M2, and CGS of the main FET. Consequently, GaN drain-to-source current IDS2 undergoes a change right at the beginning of the gate transition, not waiting for VG to reach the MOSFET threshold voltage. This modification results in a smaller di/dt value, contributing to EMI mitigation and reducing switching ringing.

As VG increases, the M2 source-to-body voltage VSB also rises, leading to an increased threshold voltage and channel ON resistance of M2. The deliberate design choice of increasing RON_M2 results in a reduced charging current, designed to extend the plateau duration. This deliberate extension leads to a reduced dv/dt value, further aiding in EMI mitigation and switching ringing reduction.

Further, the scenario is considered when the mid-node VM drops from high to low, triggering the state machine to turn on M1. This process rapidly charges VG to the final determined value (e.g., 5V), minimizing high Ron conduction loss. The gate driver's, i.e. the controller, adaptive methodology, as illustrated by the curve VGS2 in Figure 4, achieves shorter MOSFET turn-on time while maintaining smaller di/dt and dv/dt values compared to the conventional blue curve VGS1.

For negative inductor current iL1 and a low mid-node VM due to body diode conduction, the MOSFET turn-on speed becomes of importance to minimize body diode rectification loss once the input PWM becomes high. In this scenario, the proposed gate driver's comparator COMP1 directly triggers the state machines to turn on M1 by skipping the turn-on of M2, ensuring swift MOSFET turn-on.

Additionally, the proposed gate driver, i.e. controller, can be easily configured with senseFET for an accurate current-sensing function, eliminating the need to remove RSNS. Furthermore, the adaptive gate driving methodology removes the necessity for a gate resistor. In essence, the embodiment shown in figure 3 addresses any shortcomings of Fig. 2 by significantly enhancing EMI performance and self-drive capability.

Other variations to the disclosed embodiments can be understood and effected by those skilled in the art in practicing the claimed invention, from a study of the drawings, the disclosure, and the appended claims. The provided figures and descriptions of the embodiments of the invention are illustrative and explanatory to the heart of the invention and should not be seen as limiting the invention thereto. In the claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Any reference signs in the claims should not be construed as limiting the scope thereof.

## Claims

1. A switching stage of a Switched Mode Power Supply, SMPS, said switching stage comprising:
- a switching element comprising a GaN transistor connected in series with a Metal-Oxide-Semiconductor, MOS, Field Effect Transistor, FET, thereby defining a mid-node in between said GaN transistor and said MOSFET;
- a controller arranged for driving a gate terminal of said MOSFET based on an Pulse Width Modulation, PWM, input signal;
wherein said controller comprises:
- first switch circuitry arranged for providing a low ohmic path between said mid-node and said gate terminal of said MOSFET;
- control circuitry arranged for controlling said switch circuitry based on said PWM input signal.

2. A switching stage in accordance with claim 1, wherein said switching stage further comprises:
- a buffer capacitor;
- a rectifying device connected in between said mid-node and said buffer capacitor, such that said buffer capacitor is charged from said mid-node;
- a voltage regulator, connected to said buffer capacitor, and arranged for providing a supply voltage;
wherein said controller further comprises:
- second switch circuitry arranged for providing a low ohmic path between said supply voltage and said gate terminal of said MOSFET of said switching element;
wherein said control circuitry is further arranged for controlling said second switch circuitry based on a voltage level of said mid-node and based on said PWM input signal.

3. A switching stage in accordance with claim 2, wherein said controller further comprises:
- a first comparator arranged for comparing said voltage at said mid-node with a predefined first reference voltage, wherein said control circuitry is arranged for controlling said second switch circuitry based on said comparison.

4. A switching stage in accordance with any of the previous claims, wherein said first switch circuitry comprises:
- a first control MOSFET, wherein a drain terminal of said first control MOSFET is connected to said mid-node, and wherein a source terminal of said first control MOSFET is connected to said gate terminal of said MOSFET of said switching element.

5. A switching stage in accordance with claim 4, wherein a body terminal of said first control MOSFET is connected to ground.

6. A switching stage in accordance with any of the previous claims and at least to claim 2, wherein said second switch circuitry comprises:
- a second control MOSFET, wherein a source terminal of said second control MOSFET is connected to said supply voltage, and wherein a drain terminal of said second control MOSFET is connected to said gate terminal of said MOSFET of said switching element.

7. A switching stage in accordance with any of the previous claims, wherein said control circuitry is further arranged for controlling said first switch circuitry based on said PWM input signal and based on a voltage level at said gate terminal of said MOSFET of said switching element.

8. A switching stage in accordance with claim 7, wherein said control circuitry further comprises:
- a second comparator arranged for comparing said voltage level at said gate terminal of said MOSFET of said switching element with a predefined second reference voltage, wherein said control circuitry is arranged for controlling said switch circuitry based on said PWM input signal and based on said comparison.

9. A Switched Mode Power Supply, SMPS, comprising a switching stage in accordance with any of the previous claims.

10. An SMPS in accordance with claim 9, wherein said SMPS is any of:
- a flyback converter;
- a boost converter;
- a buck converter;
- a forward converter;
- a resonant converter.

11. A method of operating a switching stage in accordance with any of the claims 1 - 8, wherein said method comprises the steps of:
- controlling, by said control circuity, said switch circuitry based on said PWM input signal.

12. A method in accordance with claim 11, wherein said step of controlling comprises:
- enabling, by said control circuitry, said switch circuitry such that said switch circuitry provides said low ohmic path between said mid-node and said gate terminal of said MOSFET upon a transition in said PWM input signal.

13. A method in accordance with any of the claims 11 - 12, in combination with claim 2, wherein said method further comprises the step of:
- controlling, by said control circuity, said second switch circuitry based on said voltage of said mid-node and based on said PWM input signal.

14. A method in accordance with claim 13, wherein said controller further comprises a first comparator, wherein said method further comprises the step of:
- comparing, by said first comparator said voltage at said mid-node with a predefined first reference voltage,
And wherein said step of controlling comprises:
- controlling, by said control circuitry, said second switch circuitry based on said comparison.

15. A computer program product comprising a computer readable medium having instructions stored thereon which, when executed by a controller of a Switched Mode Power Supply, SMPS, cause said SMPS to implement a method in accordance with any of the claims 11 - 14.
